(19) **Europäisches Patentamt / European Patent Office / Office européen des brevets**

(11) **EP 1 368 891 B1**

(12) **EUROPEAN PATENT SPECIFICATION**

(45) Date of publication and mention
of the grant of the patent:
**25.12.2013 Bulletin 2013/52**

(51) Int Cl.:
*H03C 3/09* (2006.01)  *H03C 3/40* (2006.01)
*H03F 3/24* (2006.01)  *H04L 27/36* (2006.01)

(21) Application number: **01989865.9**

(22) Date of filing: **24.10.2001**

(86) International application number:
**PCT/US2001/046111**

(87) International publication number:
**WO 2002/037666 (10.05.2002 Gazette 2002/19)**

(54) **IQ MODULATOR**

I/Q MODULATOR

MODULATEUR IQ

(84) Designated Contracting States:
**AT BE CH CY DE DK ES FI FR GB GR IE IT LI LU MC NL PT SE TR**

(30) Priority: **31.10.2000 US 703037**
**22.12.2000 US 746823**

(43) Date of publication of application:
**10.12.2003 Bulletin 2003/50**

(60) Divisional application:
**10180932.5 / 2 330 733**

(73) Proprietor: **Telefonaktiebolaget L- M Ericsson (publ)**
**164 83 Stockholm (SE)**

(72) Inventors:
 • **BENGTSSON, Erik, L.**
  **S-241 35 Eslov (SE)**
 • **HADJICHRISTOS, Aristotle**
  **Apex, NC 27502 (US)**
 • **JUSTICE, Scott, R.**
  **Durham, NC 27713 (US)**
 • **CAMP, William, O., Jr.**
  **Chapel Hill, NC 27514 (US)**
 • **GORE, Charles, Jr.**
  **McKinney, TX 75070 (US)**
 • **PEHLKE, David, R.**
  **Chapel Hill, NC 27514 (US)**
 • **CAIRNS, Steven, G.**
  **Louisburg, NC 27549 (US)**
 • **KHATIBZADEH, M., Ali**
  **Morrisville, NC 27560 (US)**
 • **SCHLANG, Jeffrey**
  **Dallas, TX 75252 (US)**

(74) Representative: **HOFFMANN EITLE**
**Patent- und Rechtsanwälte**
**Arabellastrasse 4**
**81925 München (DE)**

(56) References cited:
**EP-A- 0 905 878    EP-A- 0 998 088**
**EP-A1- 1 170 915    WO-A1-00/59172**
**WO-A1-95/16304    US-A- 4 481 672**
**US-A- 5 313 173    US-A- 5 420 536**

EP 1 368 891 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## Field of the Invention

This invention relates to modulation systems and methods, and more particularly to IQ modulation systems and methods.

## Background of the Invention

Modulation systems and methods are widely used in transmitters to modulate information including voice and/or data onto a carrier. The carrier may be a final carrier or an intermediate carrier. The carrier frequency can be in UHF, VHF, RF, microwave or any other frequency band. Modulators also are referred to as "mixers" or "multipliers". For example, in a wireless communications terminal such as a mobile radiotelephone, a modulator can be used for the radiotelephone transmitter.

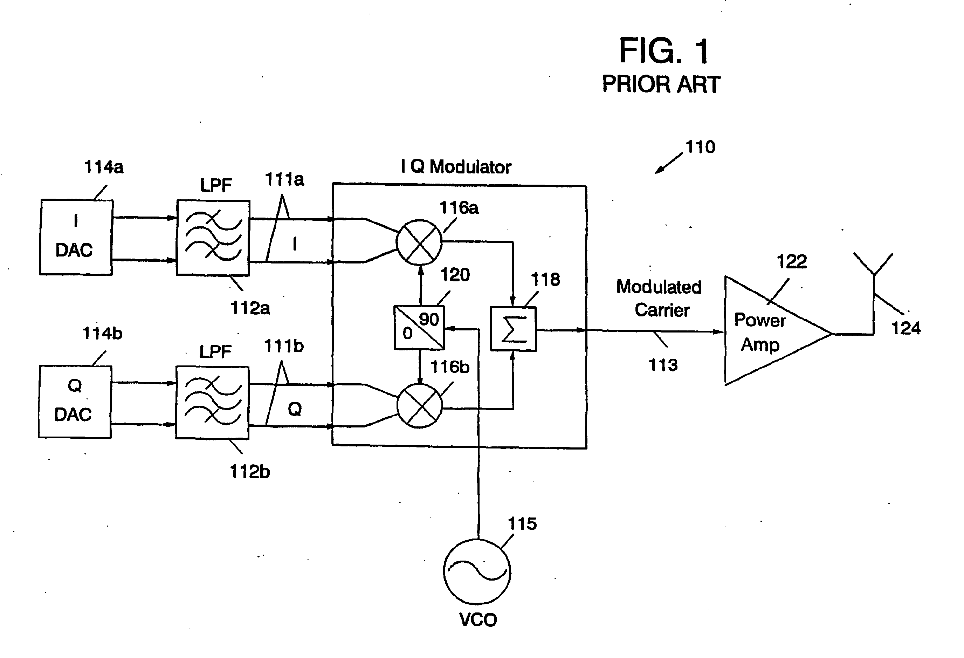

Figure 1 illustrates a conventional IQ modulator. As shown in Figure 1, an IQ modulator **110,** also referred to as a "quadraphase modulator" or a "quadrature modulator", includes a quadrature splitter **120,** also known as a 90° phase shifter, and a pair of multipliers **116a, 116b** coupled to the quadrature splitter. A controlled oscillator **115,** such as a Voltage Controlled Oscillator (VCO), is coupled to the quadrature splitter **120** to produce 90° phased shifted oscillator signals. In-phase (I) data **111a** and quadrature-phase (Q) data **111b** are coupled to a respective multiplier or mixer **116a, 116b.** Digital input data is converted to analog data by I Digital-to-Analog Converter (DAC) **114a** and Q DAC **114b,** respectively. The outputs of the respective DACs **114a** and **114b** are applied to the respective low pass filters **112a** and **112b** to provide the respective I and Q data inputs **111a** and **111b.** The modulator **110** modulates the input data on a carrier by summing the outputs of the multipliers **116a, 116b** at a summing node **118.** The modulated carrier **113** is amplified by a power amplifier **122** and transmitted via an antenna **124.**

In modem wireless communications, wireless communications terminals such as mobile radiotelephones continue to decrease in size, cost and/or power consumption. In order to satisfy these objectives, it generally is desirable to provide IQ modulation systems and methods that can provide high power modulation while reducing the amount of battery power that is consumed. Unfortunately, the power amplifier **122** of an IQ modulator may consume excessive power due to efficiency limitations therein. More specifically, it is known to provide a linear class-A or class-AB power amplifier **122** that may have efficiencies as low as 30 percent or less. Thus, large amounts of battery power may be wasted as heat. Moreover, the noise figure of a conventional IQ modulator may be excessive so that high cost Surface Acoustic Wave (SAW) filters may need to be used.

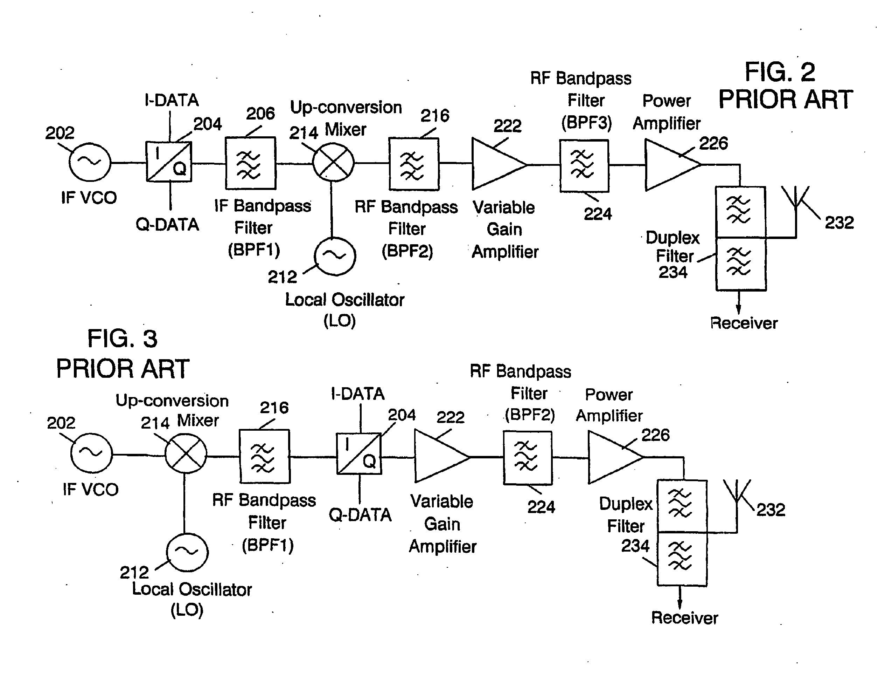

Figure 2 illustrates other conventional modulation systems. As shown in Figure 2, I-data and Q-data is modulated on an Intermediate Frequency (IF) signal supplied by a controlled oscillator such as a voltage controlled oscillator **202** by applying the I-data and Q-data and the output of the IF voltage controlled oscillator **202** to an IQ modulator **204.** The output of the modulator is then bandpass filtered by an IF bandpass filter **206.** A local oscillator **212** and an up-conversion mixer **214** are used to up-convert the output of the bandpass filter **206** to a desired radio frequency. The output of the up-conversion mixer **214** is bandpass filtered by a radio frequency bandpass filter **216** to reduce noise and spurious levels. The filtered signal is then amplified using a variable gain amplifier **222** to provide the appropriate signal level to a power amplifier **226** which delivers the signal to an antenna **232** via a duplex filter **234.** Additional RF bandpass filtering **224** may be used between the variable gain amplifier **222** and the power amplifier **226.**

Figure 3 is a block diagram of other conventional modulation systems wherein like elements to Figure 2 are labeled with like numbers. The approach shown in Figure 3 is similar to that of Figure 2 except the IF signal is up-converted to the RF band first and then modulated in the IQ modulator **204.**

Unfortunately, in either of the conventional approaches of Figures 2 or 3, the IQ modulator **204,** up-conversion mixer **214** and/or the variable gain amplifier **222** may generate significant amounts of additive noise and spurious levels which may need to be filtered before the signal reaches the power amplifier **226.** Systems of Figures 2 and 3 also may suffer from high current consumption and may need to use an excessive number of filters to meet the desired output spurious level and desired noise level.

It also is known to separately modulate the amplitude and phase of an input signal using an "rTheta" technique. In the rTheta technique, the phase is modulated at the oscillator, and the amplitude is modulated at the power amplifier stage. Unfortunately, the rTheta technique may require the oscillator phase locked loop to support the phase modulation bandwidth. With wide bandwidth radiotelephone signals such as TDMA and CDMA signals, it may be increasingly difficult to provide the requisite bandwidth in the oscillator phase locked loop.

Other relevant prior art modulation systems are known e.g. from documents US 5 412 351 A, EP 0 998 088 A, WO 00/59172 A, EP 1 170 915 A, US 5 313 173 A, WO 95/16304 A, US 4 481 672 A.

## Summary of the Invention

Embodiments of the present invention provide modulation systems according to any of the appended claims.

## Brief Description of the Drawings

Figures 1-3 are block diagrams of conventional IQ modulators; and
Figures 4-22 are block diagrams of IQ modulation systems and methods.

## Detailed Description of Preferred Embodiments

The present invention now will be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout. It will be understood that when an element is referred to as being "between" other elements, it can be directly between the other elements or intervening elements may also be present. In contrast, when an element is referred to as being "directly between" other elements, there are no intervening elements present.

Embodiments of the present invention stem from a realization that potential shortcomings of the systems of Figures 2 and 3 may arise from the two mixing (heterodyning) operations that are performed. In particular, a frequency mixing occurs in the up-conversion mixer **214** and in the IQ modulator **204** which may include two double balanced mixers. The frequency mixing may inherently generate high spurious levels and/or noise. Moreover, while some spurious levels far from the transmit carrier can be attenuated by the filters **206, 216** and **224,** other levels may be within the allowed transmission band of the transmitter and may not be filtered. Moreover, the amount of filtering to reduce the output noise and spurious levels may exceed that which can be achieved with a single RF filter. Thus, multiple filters may need to be placed in the modulator. This also can add cost and/or space to the system. Finally, in order to reduce distortion of the modulated signal (information plus the carrier) and to meet transmit voice quality needs, the up-conversion mixer **214,** the IQ modulator **204** and the variable gain amplifier **222** may run at high current levels, which can reduce the operating time and generate excessive heat for portable wireless communication terminals.

Embodiments of the present invention can reduce the output noise and/or spurious levels so that the need for additional filters may be reduced and preferably may be eliminated. Moreover, the current consumption of an *IQ* modulator can be reduced while still meeting a desired linearity.

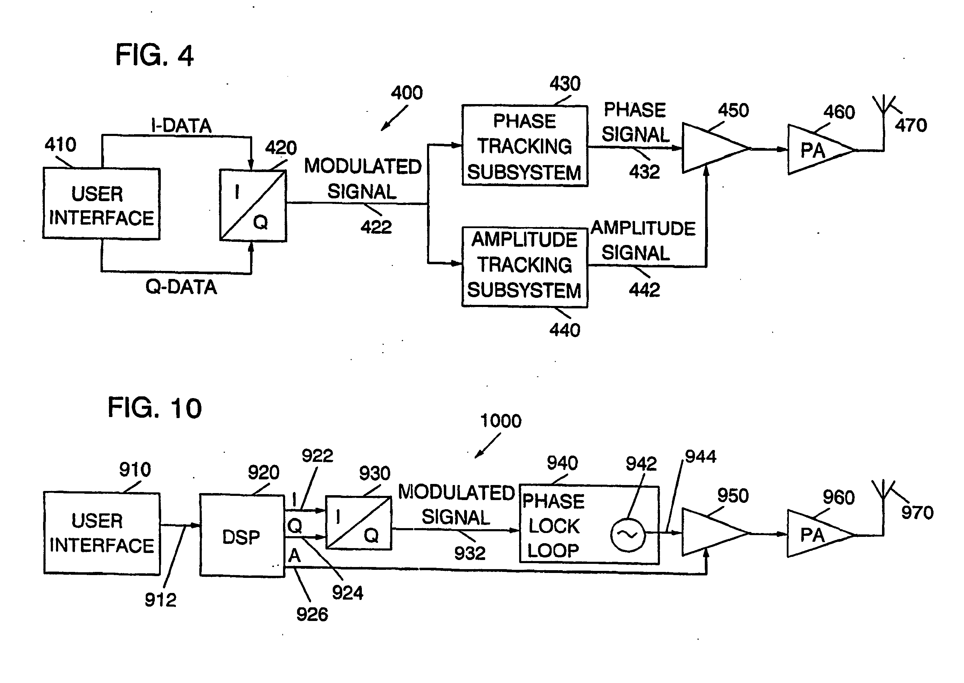

Referring now to Figure 4; modulation systems and methods are shown. As shown in Figure 4, these modulation systems and methods **400** include a quadrature (IQ) modulator **420** that modulates in-phase and quadrature-phase signals, referred to as I-data and Q-data, that may be generated by a user interface **410** in response to user commands, to produce a modulated signal **422.** A phase tracking subsystem **430** is responsive to the quadrature modulator **420** to produce a phase signal **432** that is responsive to phase changes in the modulated signal **422** and that is independent of amplitude changes in the modulated signal **422.** An amplitude tracking subsystem **440** also is included that is responsive to the modulator **420** to produce an amplitude signal **442** that is responsive to amplitude changes in the modulated signal and that is independent of phase changes in the modulated signal **422.** An amplifier **450** includes a signal input, an amplitude or gain control input and an output. The signal input is responsive to the phase signal **432.** The amplitude control input is responsive to the amplitude signal **442** and the output is applied to a transmit antenna **470,** optionally via a power amplifier **460.** Alternatively, the amplifier **450** may be a power amplifier.

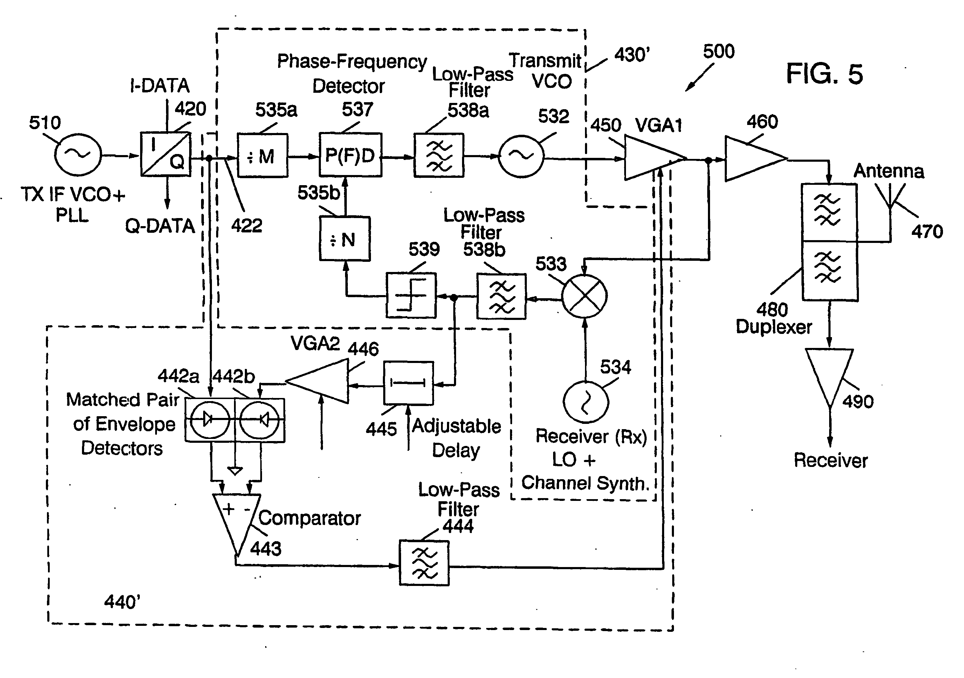

Referring now to Figure 5, other modulation systems and methods are shown. As shown in Figure 5, these modulation systems and methods 500 include an IQ modulator **420,** a phase tracking subsystem **430',** an amplitude tracking subsystem **440',** an amplifier **450,** a power amplifier **460** and an antenna **470.** As shown, the transmitter carrier frequency is generated using a fundamental radio frequency controlled oscillator such as a voltage controlled oscillator **532** which can have an extremely high signal-to-noise ratio, on the order of -165dBc/Hz at 45MHz away. The output signal level is controlled using an amplifier **450** such as a saturated variable gain amplifier. The information signal  (I-data and Q-data) is first modulated on an IF signal using the IQ modulator **420.** The IF signal is generated by a separate fundamental controlled oscillator such as a voltage controlled oscillator **510.** The modulated signal then is provided to separate amplitude and phase tracking subsystems in the form of amplitude and phase tracking loops **440'** and **430',** respectively. The modulated IF signal **422** acts as a reference for amplitude and phase comparators in the two corresponding tracking loops **440'** and **430'.** The RF output signal from the amplifier **450** is mixed down to the IF frequency using a system local oscillator **534.** The VCO **532** is phase locked using the phase locked loop that includes dividers **535a, 535b,** a phase-frequency detector or a phase detector **537,** a pair of low pass filters **538a** and **538b,** and a limiter **539.** This phase locked loop acts as the channel synthesizer for the transmitter. The output of the mixer **533** is low pass filtered via low pass filter 538b and fed to the limiter **539** along with the modulated reference IF signal **534.**

In the phase tracking loop **430',** optional RF dividers **535a** and 535b are placed in the reference and compare arms of the phase-frequency detector **537** to divide by M and N respectively. Since practical implementation of phase-frequency detectors at high frequencies may be difficult, this can allow for the lowering of the comparison frequency and can have negligible effect on the phase comparison. It also will be understood that the dividers **535a** and **535b** may be set such that M=N, or M=N=1, or may be eliminated.

In the amplitude-tracking loop **440',** a pair of matched envelope detectors **442a** and **442b** are used to compare the amplitude level of the down-converted IF signal or other signal from the phase locked loop to that of the modulated signal **422.** Good matching between the two envelope detectors **442a** and **442b** may be provided to reduce AM offsets in the loop. Also, an adjustable constant delay element **445** may be introduced in the amplitude tracking loop **440'** to match the total group delay for the amplitude and phase signals. If the total delay is not matched, the output signal may not have the desired modulation characteristics.

Since the output power level of the transmitter is controlled by the amplifier **450** (VGA1) over a wide range, the total loop gain may change for the amplitude and phase tracking loops. In the phase tracking loop, the limiter **539** and/or the limiting action of the phase detector **537** can maintain constant loop gain, while, in the amplitude tracking loop **440',** a separate variable gain amplifier **446** (VGA2) with the opposite gain versus control voltage slope as the amplifier **450** is used. As the gain of VGA1 **450** is reduced to reduce output signal level, the gain of VGA2 **446** may be increased by the same amount to keep the signal level into the matched envelope detectors **442a, 442b** nearly constant. Otherwise, the envelope detectors **442a, 442b** may need to have good matching over a very large (>50dB) range of signal levels at the input. Such wide dynamic range envelope detectors may be difficult to implement. One additional potential advantage of systems of Figure 5 is that the AM/PM distortion in VGA1 **450** is compensated in the phase tracking loop **430'.** This can help achieve low phase and amplitude error over a wide range of output power levels.

The output signals of the phase and amplitude detectors are filtered using low-pass filters **538a, 444** which can have bandwidths large enough to pass the modulation signal (baseband) but narrow enough to suppress noise and spurious levels outside the modulation bandwidth. In effect, the low-pass filters **538a, 538b** and **444** in the phase and amplitude tracking loops **440'** and 430' can act as bandpass filters on the RF transmit carrier signal with very narrow bandwidth (i.e., very high-Q). For example, for 30kHz modulation bandwidth (common to digital wireless phones), the low-pass filter bandwidth can be less than 1MHz. Therefore, the low-pass filter in the loop can be equivalent to a bandpass filter centered at the transmit frequency (e.g., 825MHz) having a bandwidth of less than 1MHz (Q>825). The noise and spurious levels outside the 1MHz bandwidth around the carrier are attenuated according to the attenuation characteristics of the low-pass filters in the tracking loops. Such low-pass filters can be implemented with resistors and capacitors, and thus can eliminate the need for expensive, multiple SAW filters.

Direct amplitude modulation of power amplifiers (especially saturated class-D power amplifiers) may be known. Some systems can provide electrical isolation between the modulation loop and the antenna. For example, systems of Figure 5 can utilize the power amplifier **460** as an isolator providing electrical isolation between the antenna **470** and the transmit modulator. In this case, the efficiency of the amplifier (VGA1) **450** may not be as important to the overall power consumption. Therefore, it can be easier to implement simultaneous AM modulation and large power control range in VGA1. The amplifier **450** can be designed to operate in a fixed high-efficiency, linear mode without the need for dynamic bias adjustment. Alternatively, other systems can amplitude modulate the power amplifier itself. This can provide enhanced linearity margin and/or enhanced efficiency by utilizing a saturating power amplifier and restoring envelope amplitude through modulation of its supply.

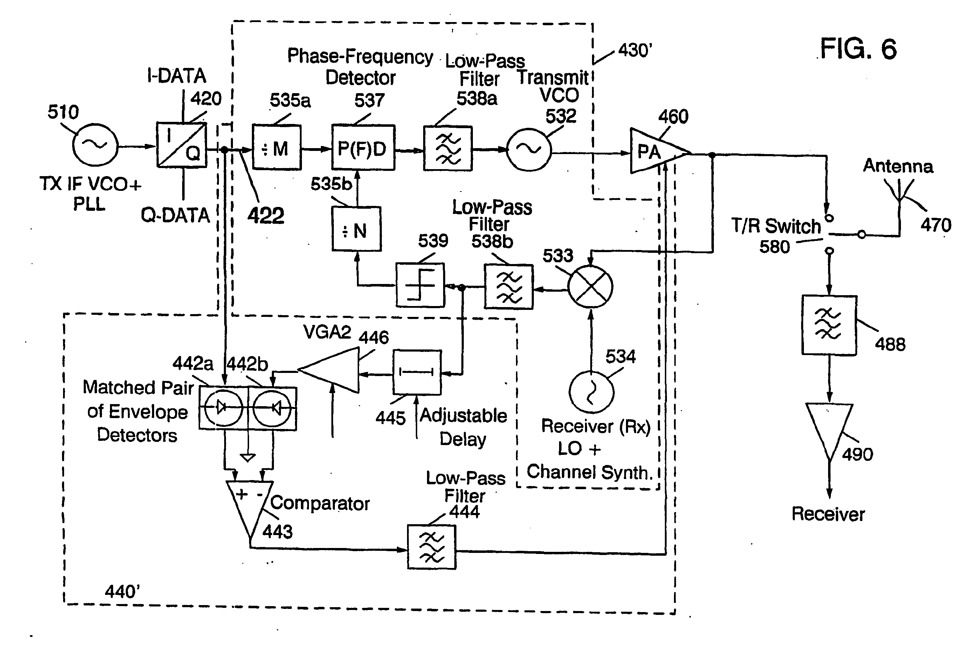

Figure 6 depicts modulation systems in a half-duplex system such as a TDMA-only IS-136 terminal or an EDGE terminal. In this case, the signal-to-noise ratio of the transmitter can be high enough so that the duplexer filter **480** of Figure 5 can be replaced by a transmit-receive (T/R) switch **580** in the transmit path. Also in Figure 6, the power amplifier **460** itself is amplitude modulated.

It also will be understood by those having skill in the art that in Figures 5 and 6, the input to the mixer **533** may be taken between the VCO **532** and the amplifier **450** rather than between the output of the amplifier **450** and the power amplifier **460** as illustrated.

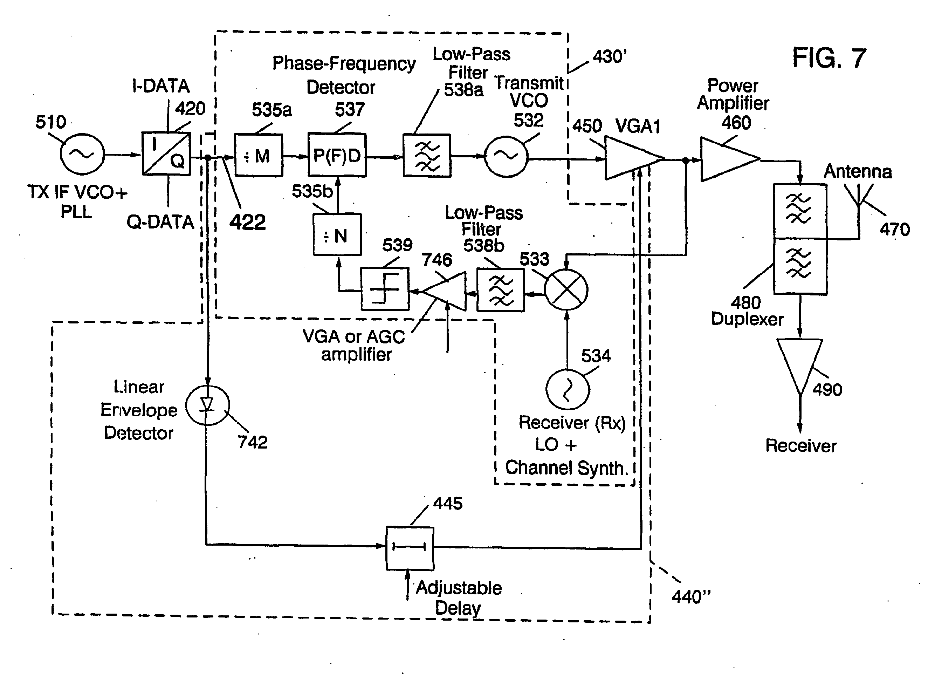

Figure 7 is a block diagram of other modulation systems and methods. In these systems, the amplitude tracking subsystem **440"** is implemented as a direct modulation or an open loop. This may be accomplished, for example, if an amplifier **450** having a linear voltage control characteristic is used. Such a circuit is feasible with integrated circuit design techniques. For systems of Figure 7, the divide ratio of the phase locked loop is one so that M and N are set to 1 or no dividers **535a, 535b** are used. The IF amplifier **746** after the down-converting mixer **533** can be either a variable gain amplifier or an AGC amplifier. This amplifier **746** may be used in order to reduce the input operating range of the limiter **539**. The AM/PM distortion of the limiter **539** thereby can be reduced. In Figure 7 the amplitude tracking subsystem **440"** includes an envelope detector **742** such as a diode and an adjustable delay **445**.

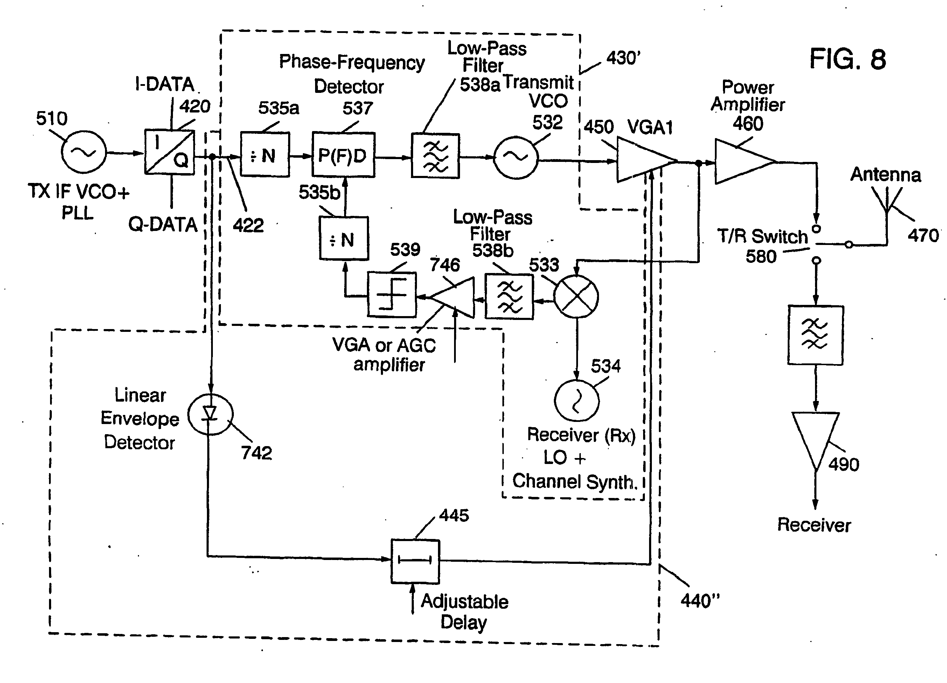

Figure 8 depicts systems that can be used in a half-duplex system such as a TDMA-only IS-136 terminal or an EDGE terminal. In Figure 8, the signal-to-noise ratio of the transmitter can be high enough so that the duplexer filter **480** can be replaced by a transmit-receive (T/R) switch **580** in the transmit path that couples to a receiver amplifier **490**.

It will be understood that if the phase-frequency detector **537** is difficult to implement as a low current standard integrated circuit solution then a standard active analog phase detector such as a Gilbert cell mixer can be used. Assisted acquisition techniques then may be used to provide fast lock times for the PLL.

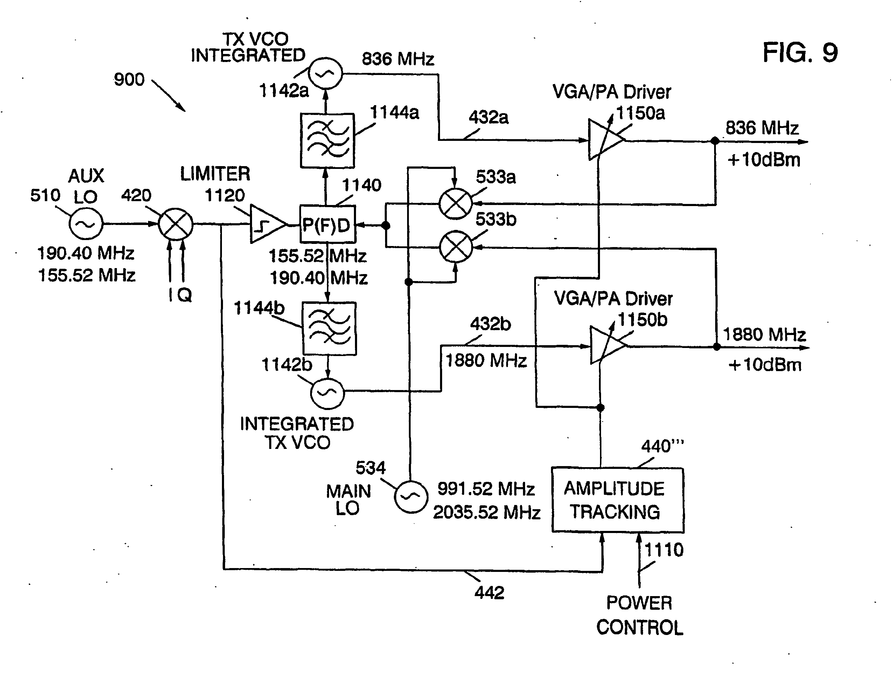

Figure 9 is a block diagram of modulation systems and methods. Figure 9 illustrates dual mode modulation systems and methods 900 that can produce cellular and PCS signals. As shown in Figure 9, a phase locked loop includes phase frequency detector or phase detector 1140 and a low pass filter 1144a, 1144b and a controlled oscillator such as a VCO 1142a, 1142b for each mode. A main local oscillator 534 and a pair of mixers 533a, 533b also are provided. An amplitude tracking subsystem 440"' also may be responsive to a power control signal 1110. A pair of variable gain amplifiers and/or power amplifiers 1150a, 1150b may be provided. A limiter 1120 also is provided between the modulator 420 and the phase frequency detector 1140.

In summary, systems of Figures 4-9 can deliver low-distortion complex modulation signals containing both amplitude and phase information, with very high signal-to-noise ratio (for example on the order of -165dBc/Hz at 45mHz offset) to a power amplifier. These systems can reduce or eliminate the need for SAW filters that are traditionally used in conventional digital radio transmitter architectures. They also can reduce power consumption and spurious products compared to the conventional up-mixing transmitters.

Referring now to Figure 10, a block diagram of other modulation systems and methods according to the present invention is shown. As shown in Figure 10, these modulation systems and methods 1000 include a Digital Signal Processor (DSP) 920 that generates in-phase (I), quadrature-phase (Q) and amplitude (A) signals 922, 924 and 926, respectively, from a baseband signal 912 that may be generated by a user interface 910. A modulator such as an IQ modulator 930 modulates the in-phase and quadrature-phase signals 922 and 924, respectively, to produce a modulated signal 932. A phase locked loop 940 is responsive to the modulated signal. The phase locked loop 940 includes a controlled oscillator 942 having a controlled oscillator output 944. An amplifier 950 includes a signal input, an amplitude or gain control input and an output. The signal input is responsive to the controlled oscillator output 944 and the amplitude control input is responsive to the amplitude signal 926. An optional power amplifier 960 is responsive to the output of the amplifier 950. A transmit antenna is responsive to the power amplifier 960 and/or amplifier 950.

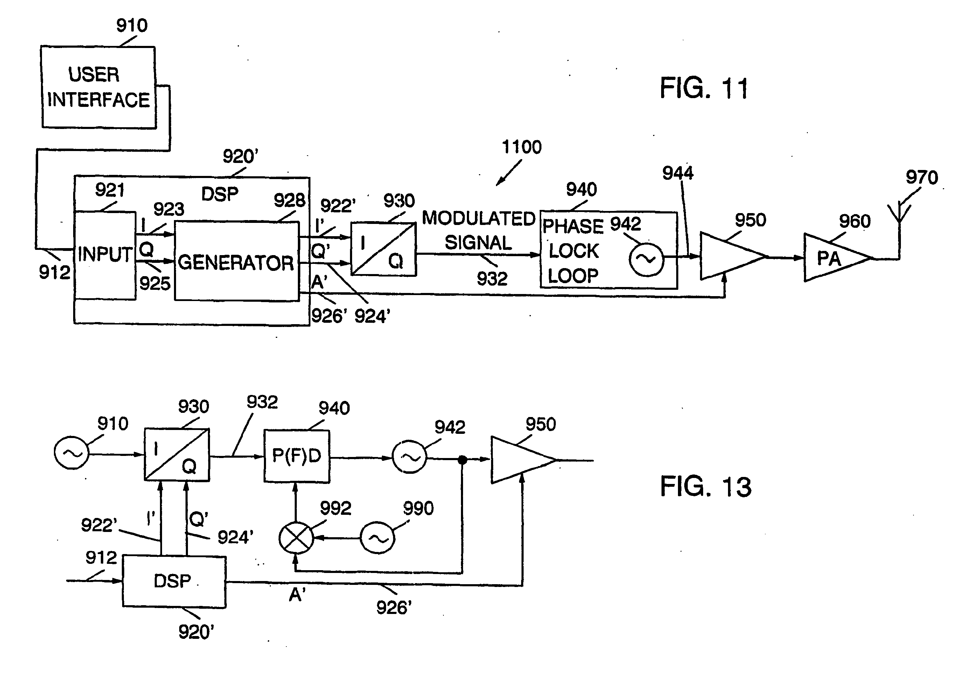

Figure 11 illustrates other modulation systems and methods 1100. As shown in Figure 11, the digital signal processor 920' generates in-phase I and quadrature-phase Q signals 923 and 925, respectively, from a baseband signal 912 at the input 921 thereof. A generator 928 within the digital signal processor 920' then generates normalized in-phase (I') and quadrature-phase (Q') signals 922' and 924' and a normalized amplitude signal 926'. It will be understood that the generator 928 may be embodied as a hardware and/or software module in the digital signal processor 920', and that the signals 922', 924' and 926' may be generated directly from the baseband signal 912, without the need to generate the intermediate signals 923, 925. The normalized in-phase and quadrature signals 922' and 924' are applied to a modulator such as an IQ modulator 930, such that the modulated signal 936 is of constant amplitude, followed by a phase locked loop 940, amplifier 950, optional power amplifier 960 and antenna 970 as was described in connection with Figure 9. The normalized amplitude signal A' is applied to the gain control input of the amplifier 950.

Still referring to Figure 11, the digital signal processor 920' generates the normalized in-phase signal I' 922' as a cosine of an angle θ and generates the normalized quadrature-phase signal Q' 924' as a sine of the angle θ, where the angle θ is an angle whose tangent is the quadrature-phase signal 925 divided by the in-phase signal 923. Moreover, the normalized amplitude signal 926' is generated as the square root of the sum of the in-phase signal I 923 squared and the quadrature-phase signal Q 925 squared. It will be understood that the sine and cosine functions may be interchanged from that which is described above.

Systems of Figures 10 and 11 can mathematically manipulate I, Q and A signals to allow reduced distortion in modulators. Conventionally, I and Q signals come from the baseband section of a wireless terminal carrying the modulating information that represents a voice and/or data signal that is to be transmitted. I and Q signals also can be represented as amplitude and phase signals. As was already described, a conventional transmitter modulates a VCO with this I and Q information and then amplifies the composite signal and up-converts the frequency to the transmit frequency. In sharp contrast, systems of Figures 10 and 11 perform numerical generation of I, Q and A signals from baseband. Moreover, systems of Figure 11 generate normalized I, Q and A signals I', Q' and A', respectively, from baseband.

This can eliminate the need for a limiter to inject the signals into the phase locked loop of an rTheta architecture. The amplitude signal A' may be generated numerically from baseband such that an envelope detector may not be needed for the analog reconstruction of that signal. Amplitude direct from baseband also can allow flexible phase shifting between amplitude and phase waveforms for rTheta architectures.

More particularly, conventional modulating systems, for example as illustrated in Figures 1, 2 and 3, generate amplitude information from the IQ signal so that the rest of the transmitter chain may need to be linear enough to meet desired modulation specifications. In contrast, if the amplifiers can be saturated instead of linear, current consumption may be reduced. Moreover, conventional modulation systems may have low levels of linearity for a given current consumption. This may be especially true for modulation schemes whose peak-to-average is not a fundamental limit and even further back-off may be needed to satisfy near channel interference levels.

Moreover, systems of Figure 9 may produce an amplitude control signal **442** that may not be ideal because of distortion caused in the IQ modulator **420.** The amplitude tracking circuit **440'''** also may cause distortion. It also may be generally desirable to place a limiter **1120** between the IQ modulator **420** and the phase locked loop to remove unwanted amplitude information. The limiter **1120** may cause AM/PM distortion in the phase signal **432a, 432b** and also can cause unwanted delay between the amplitude and phase signals when they are combined at the driver stages **1150a** and **1150b.**

In contrast, systems of Figures 10 and 11 can calculate a desired output for an amplitude tracking subsystem **440** (Figure 4) and can apply this output directly. Moreover, a limiter may not be needed because limiting may already be incorporated into the generation of the I' and Q' signals.

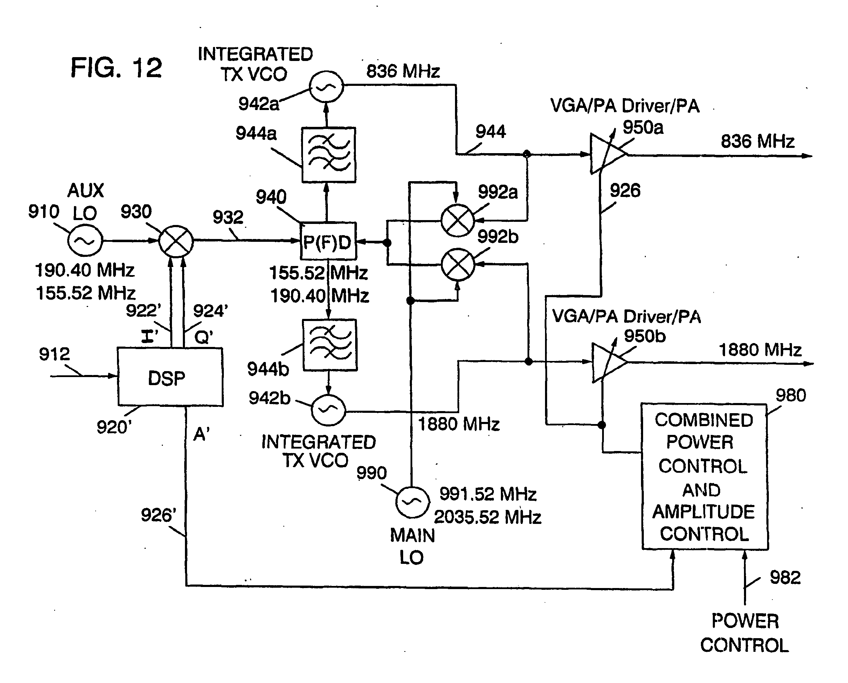

Figure 12 is a block diagram of modulating systems and methods. As shown in Figure 12, a DSP **920'** generates an I' signal **922',** a Q' signal **924'** and an A' signal **926'** from a baseband signal **912.** A controlled oscillator **910** and the I' and Q' signals **922'** and **924',** respectively, are applied to an IQ modulator **930** to produce a modulated signal **932** that is applied to a phase frequency detector or phase detector **940** including a pair of low pass filters **944a, 944b** and a pair of controlled oscillators **942a, 942b.** Also applied to the phase frequency detector **940** is a main local oscillator **990** modulated by second modulators **992a, 992b.** The output of the controlled oscillators **942a, 942b** are applied to amplifiers **950a** and **950b,** respectively, which can be variable gain amplifiers and/or other conventional amplifiers such as power amplifiers or driver amplifiers. As also shown in Figure 12, amplitude control also may be combined with a power control signal **982** in a combined power control and amplitude control module **980.** Accordingly, an improved rTheta architecture may be provided. Figure 13 is a block diagram of a single band version of Figure 12.

The following equations show how the I', Q' and A' signals may be calculated for systems of Figures 11, 12 and 13:

$$\theta = \tan^{-1}\left(\frac{Q}{I}\right)$$

The angle should be a four-quadrant representation of the I and Q-data.

$$I' = \cos\theta$$

$$Q' = \sin\theta$$

The I' and Q' signals also may be interchanged. Therefore, the I' and Q' signals can be used to modulate the IF, and can create an IF that can be identical to an IQ modulated IF signal that has passed through an ideal limiter. Since the I' and Q' signals can be free of amplitude information, a limiter may not be needed at the input of the phase-frequency detector of the phase locked loop. Phase distortion, or AM/PM distortion that may occur in a real limiter, also may be reduced or eliminated.

The A' signal is calculated as follows:

$$A' = \sqrt{I^2 + Q^2}$$

Since the A'signal is calculated mathematically and applied directly to the amplifier, it need not contain any of the distortion created in the IQ modulation of the IF, and it also need not contain any distortion from the amplitude detector circuit.

Accordingly, limiters/envelope detectors may be removed and related AM/PM distortion may be reduced or eliminated. VCO pulling also may be removed that may arise from amplitude variations on a phase only signal. Sending the amplitude directly from baseband can result in exact and repeatable power control, as well as flexibility in phase shifting of amplitude relative to phase only signals in rTheta transmitters.

Systems that were described in Figures 4-13 placed the quadrature modulator prior to the phase locked loop. Thus, for example, in Figures 4-8, the IQ modulator **420** modulates in-phase and quadrature phase signals, and provides a modulated signal **422** to a phase locked loop in a phase tracking system **430** or **430'.** Similarly, in Figures 10-11, the IQ modulator **930** modulates I and Q signals and provides the modulated signal **932** to a phase locked loop **940.** Thus, in these embodiments, the IQ modulation may take place at the IF frequency by directly modulating the IF reference signal.

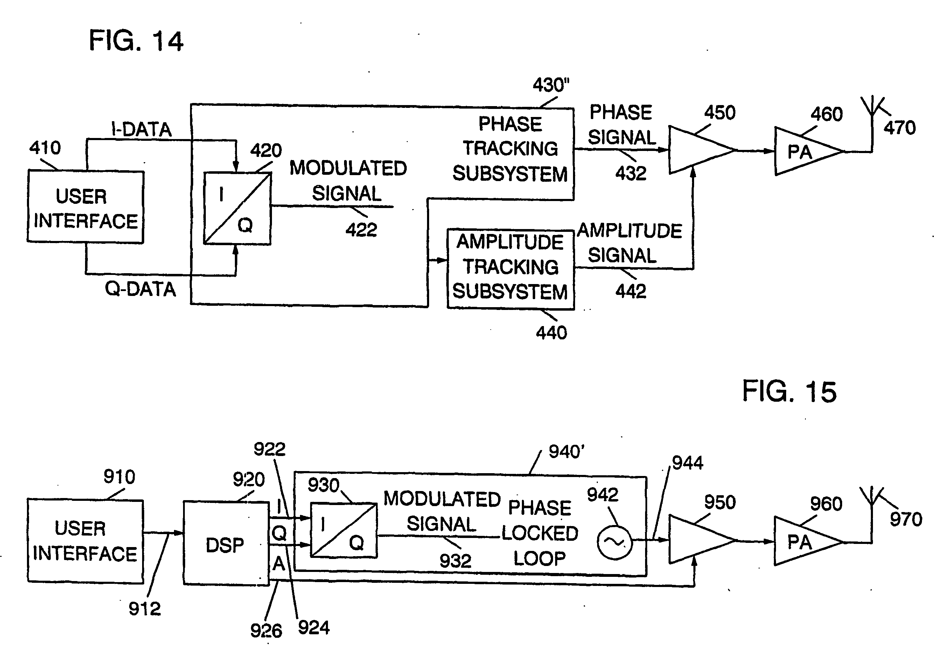

According to other systems that will be described below in connection with Figures 14-22, modulation is applied within the phase locked loop itself. In particular, the phase locked loop includes a controlled oscillator having a controlled oscillator input and a controlled oscillator output, and a feedback loop between the controlled oscillator input and the controlled oscillator output. The feedback loop includes a mixer that is responsive to a local oscillator. In some systems, the modulator is placed in the feedback loop between the controlled oscillator output and the mixer, between the local oscillator and the mixer, or between the mixer and the controlled oscillator input. Accordingly, the modulation can be applied by modulating a local oscillator signal and leaving the IF as an unmodulated signal. Alternatively, the modulation can be applied to the RF output, and then mixed with an unmodulated local oscillator and IF frequency. In yet another alternative, the modulation may be performed after the mixer in the feedback path of the phase locked loop if it is desired to keep the IQ modulator running at the IF frequency.

For example, Figure 14 is similar to Figure 4, except that the IQ modulator **420** is included within the phase tracking subsystem **430"**, preferably within the feedback loop of the phase locked loop of the phase tracking subsystem **430"**. Figure 15 is similar to Figure 10, except the IQ modulator **930** is included within the phase locked loop **940'**, preferably within the feedback loop thereof.

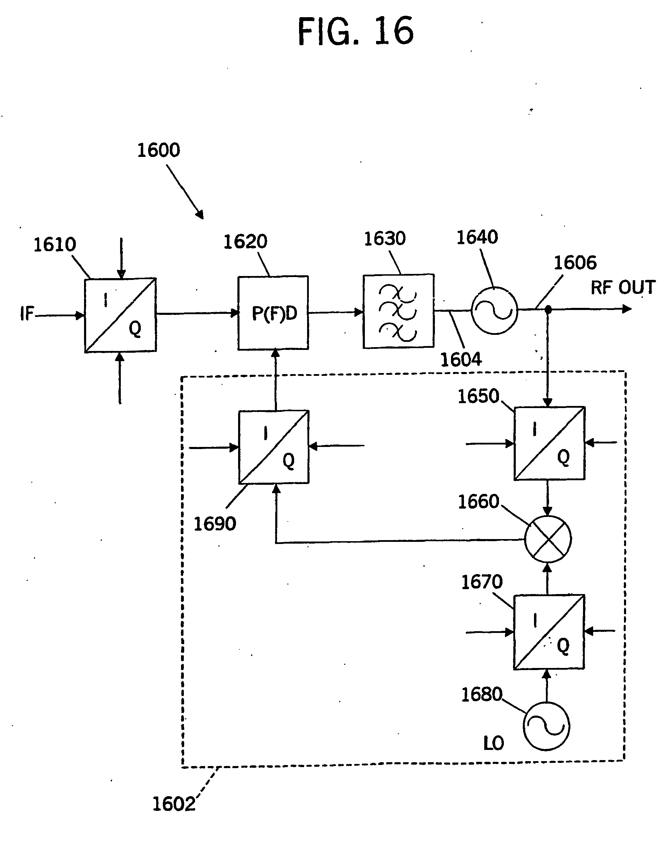

Figure 16 is a block diagram of embodiments of the invention. It will be understood that Figure 16 can correspond to the phase tracking system **430** of Figure 4, **430'** of Figures 5-8 and/or **430"** of Figure 14, and/or the phase locked loop **940** of Figures 10-13, and/or **940'** of Figure 15.

As shown in Figure 16, the phase locked loop **1600** includes a phase detector or phase-frequency detector **1620** that can correspond to the phase-frequency detector or phase detector **537** of Figures **5-8,1140** of Figure 9 and/or **940** of Figures 12-13, and a low pass filter **1630** that can correspond to the low pass filter **538a** of Figures 5-8,**1144a** of Figure 9, and/or **944a** of Figure 12. A controlled oscillator, such as a Voltage Controlled Oscillator (VCO) **1640** can correspond to the VCO **532** of Figures 5-8, **1142a, 1142b** of Figure 9, **942a, 942b** of Figure 12 and/or **942** of Figures 10, 11, 13 and 15. As also shown in Figure 16, the controlled oscillator has a controlled oscillator input **1604** and a controlled oscillator output **1606**. A feedback loop **1602** is provided between the controlled oscillator output **1606** and the controlled oscillator input **1604** via the phase-frequency detector or phase detector **1620** and low pass filter **1630**. The feedback loop includes a mixer **1660** that can correspond to the mixer **533** of Figures 5-8, **533a**, 533b of Figure 9, **922a, 922b** of Figure 12 and/or **922** of Figure 13, and a local oscillator 1680 that can correspond to the local oscillator **534** of Figures 5-9 and/or 990 of Figures 12-13.

In Figure 16, four possible locations of the IQ modulator corresponding to IQ modulator **420** of Figures 4-9 and/or **930** of Figures 10-13 are shown by IQ modulators **1610, 1650, 1670** and **1690**. According to the present invention only IQ modulator **1650** needs be provided in the feedback loop **1602** between the controlled oscillator output **1606** and the mixer **1660** as shown in Figure 16. However, multiple IQ modulators also may be provided.

In addition to IQ modulator **1650**, an IQ modulator **1610** may be placed prior to the phase locked loop **1600** in a manner corresponding to Figures 4-13 as was described extensively above. In addition to IQ modulator **1650**, an IQ modulator **1670** may be placed in the feedback loop **1602** between the local oscillator **1680** and the mixer **1660**. In addition to IQ modulator **1650**, an IQ modulator **1690** may be placed in the feedback loop **1602** between the mixer **1660** and the controlled oscillator input **1604.**

The IQ modulator **1650** being placed between the output of the controlled oscillator **1606** and the mixer **1660,** the RF output signal of the controlled oscillator **1640** is modulated with the I and Q signals. Thus, this is an example of RF modulation.

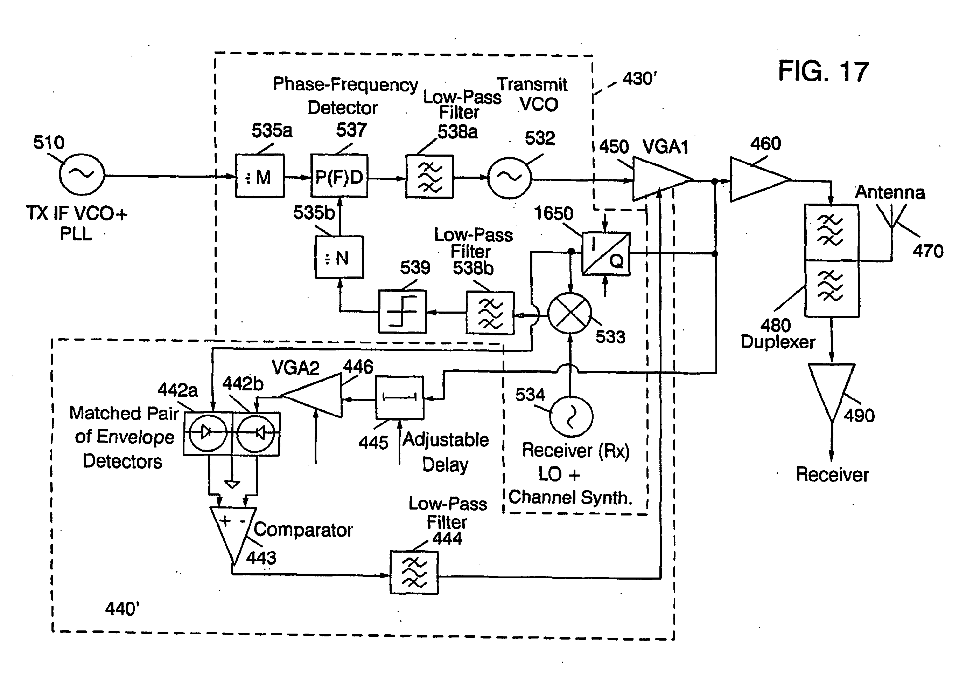

Figure 17 is a block diagram that is similar to Figure 5, except the IQ modulator **1650.** is placed in the feedback loop between the output of the controlled oscillator **532** and the mixer **533,** rather than the IQ modulator **420** of Figure 5. An IQ modulator **1670** or **1690** of Figure 16 also may be used in systems of Figure 17.

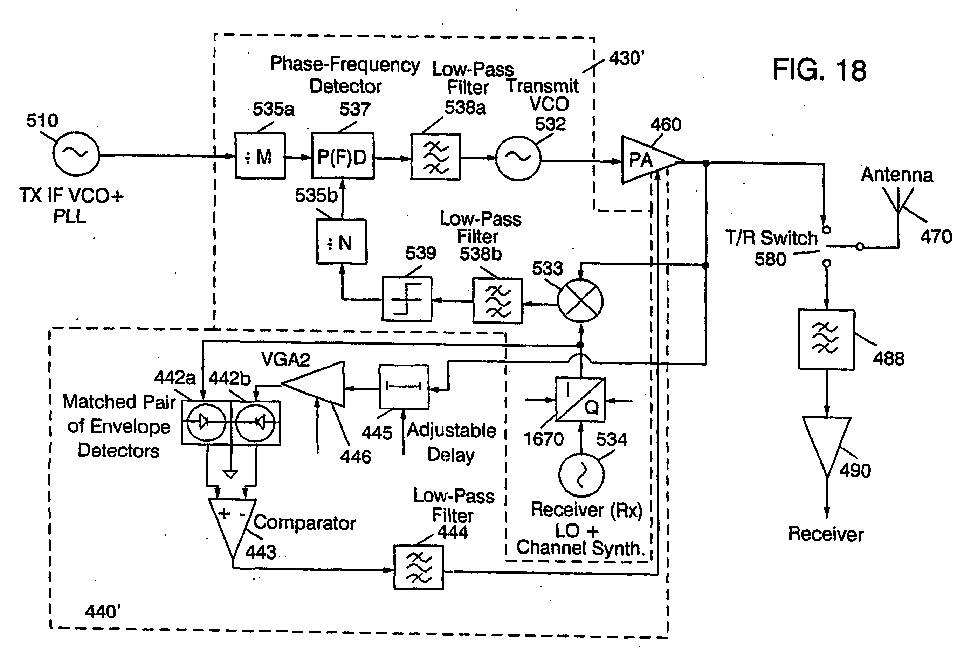

Figure 18 illustrates the use of an IQ modulator **1670** between the local oscillator **534** and the mixer **533,** instead of the IQ modulator **420** at the input of the phase locked loop in Figure 6. It will also be understood that an IQ modulator **1650** or **1690** of Figure 16 also may be employed.

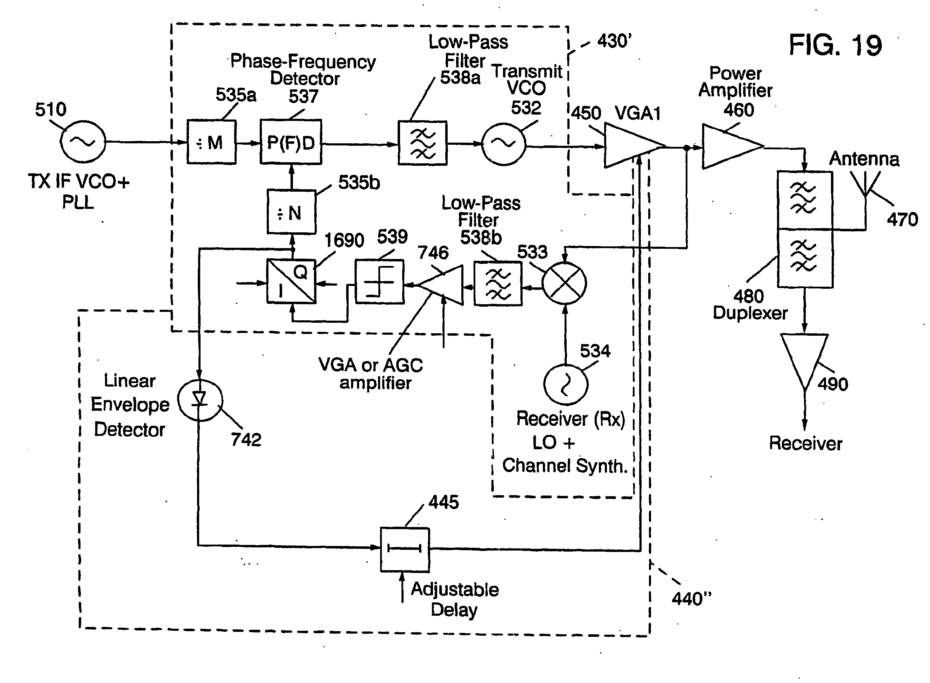

Figure 19 illustrates the use of an IQ modulator **1690** between the mixer **533** and the input of the controlled oscillator **532,** instead of the IQ modulator **420** of Figure 7. It also will be understood that IQ modulators **1650** or **1670** also may be used. IQ modulators also may be used in the positions shown in Figure 16 in other systems according to Figures to Figures 8 and 9.

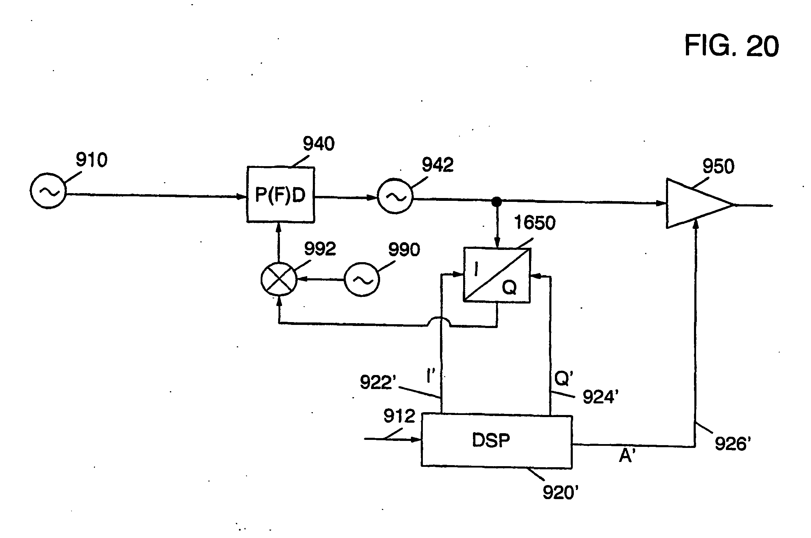

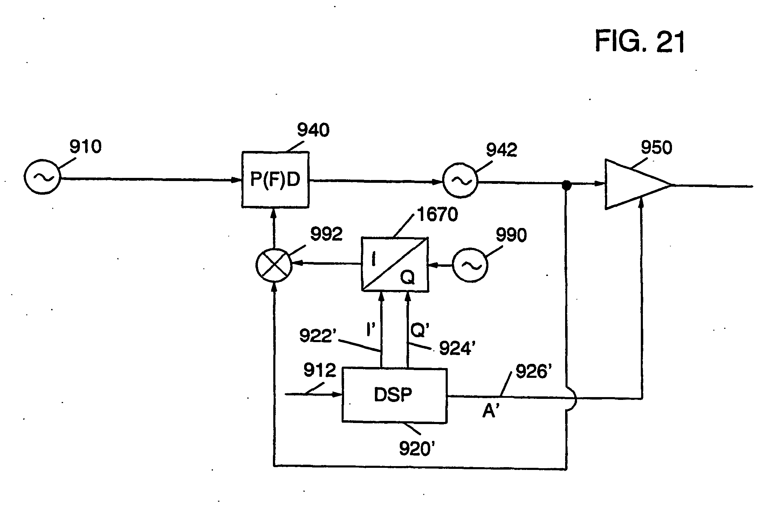

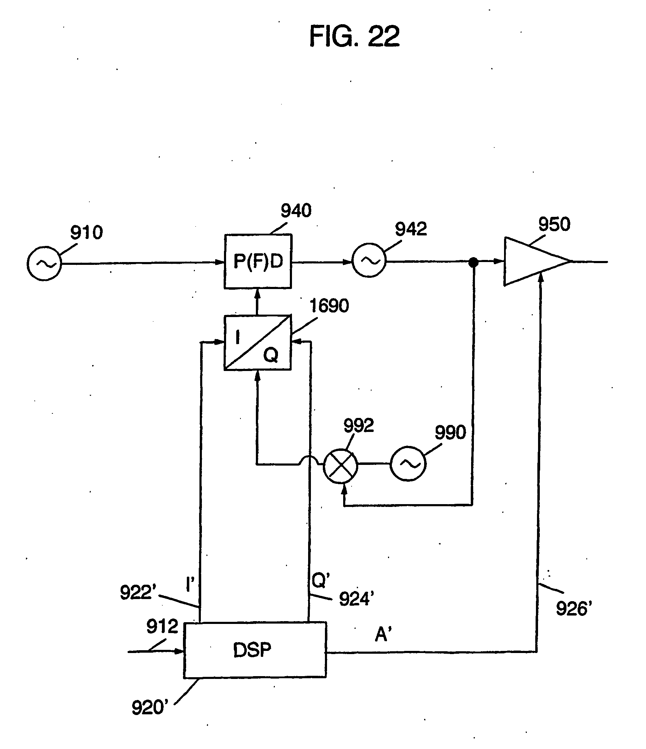

Figure 20 illustrates the use of a modulator **1650** between the output of the controlled oscillator **942** and the mixer **992,** instead of the IQ modulator **930** of Figure 13. Figure 21 illustrates an IQ modulator **1670** between the local oscillator **990** and the mixer **992,** instead of the IQ modulator **930** of Figure 13. Figure 22 illustrates an IQ modulator **1690** between the mixer **992** and the input of the controlled oscillator **942,** instead of the IQ modulator **930** of Figure 13. Similar placements of the modulator may be provided for the systems of Figure 12.

In the drawings and specification, there have been disclosed typical preferred embodiments of the invention and, although specific terms are employed, they are used in a generic and descriptive sense only and not for purposes of limitation, the scope of the invention being set forth in the following claims.

**Claims**

1. A modulation system comprising: a digital signal processor (920) that generates in-phase (922), quadrature phase (924) and amplitude signals (926) from a baseband signal (912); a modulator (930) that modulates the in-phase and quadrature phase signals to produce a modulated signal; a phase locked loop (940) that is responsive to the modulated signal, the phase locked loop including a controlled oscillator (942) having a controlled oscillator output ; and an amplifier (950) having a signal input, an amplitude control input and an output, wherein the signal input is responsive to the controlled oscillator output (944) and the amplitude control input is responsive to the amplitude signal (926),

wherein the phase locked loop includes a controlled oscillator input and the controlled oscillator output, the feedback loop including a mixer that is responsive to a local oscillator, **characterized in that** the modulator (1650) is in the feedback loop between the controlled oscillator output (1606) and the mixer (1660) wherein the modulator modulates the in-phase and quadrature-phase signals on a signal derived from the controlled oscillator (1606).

2. A system according to claim 1, wherein the in-phase and quadrature phase signals are normalized in-phase and quadrature phase signals, such that the modulated signal is a constant amplitude modulated signal.

3. A system according to claim 2, wherein the digital signal processor (920') generates the normalized in-phase signal as one of a cosine and a sine of an angle theta and generates the normalized quadrature phase signal as the other of a cosine and a sine of the angle theta, where theta is an angle whose tangent is the quadrature phase signal divided by the in-phase signal.

4. A system according to claim 3, wherein the digital signal processor (920') generates the amplitude signal as a square root of a sum of the in-phase signal squared and the quadrature-phase signal squared.

5. A system according to claim 1, further comprising a power control signal (982), wherein the amplitude control input is responsive to the amplitude signal and to the power control signal (982).

6. A system according to claim 1, farther comprising: a power amplifier (960) that is responsive to the output of the amplifier having a signal input, an amplitude control input and an output; and a transmit antenna (970) that is responsive to the power amplifier.

7. A modulation system comprising: a quadrature modulator (420) that modulates in-phase and quadrature-phase signals to produce a modulated signal; a phase tracking subsystem (430) that is responsive to the quadrature modulator (420) to produce a phase signal (432) that is responsive to phase changes in the modulated signal and that is independent of amplitude changes in the modulated signal; an amplitude tracking subsystem (440) that is responsive to the modulator (420) to produce an amplitude signal (422) that is responsive to amplitude changes in the modulated signal and that is independent of phase changes in the modulated signal;

and an amplifier (450) having a signal input, an amplitude control input and an output, wherein the signal input is responsive to the phase signal (432) and the amplitude control input is responsive to the amplitude signal (422), wherein the phase tracking subsystem (430) comprises a phase locked loop that is responsive to the modulated signal, the phase locked loop including a controlled oscillator having a controlled oscillator output that produces the phase signal, wherein the phase locked loop includes a controlled oscillator input and the controlled oscillator output, the feedback loop including a mixer that is responsive to a local oscillator, **characterized in that** the modulator (1650) is in the feedback loop between the controlled oscillator output (1606) and the mixer (1660) wherein the modulator modulates in-phase and quadrature-phase signals on a signal derived from the controlled oscillator.

8. A system according to claim 7, wherein the amplitude tracking subsystem (440) comprises an automatic gain control subsystem that is responsive to the modulated signal to produce the amplitude signal.

9. A system according to claim 8, wherein the automatic gain control subsystem further comprises: a first envelope detector (442a) that is responsive to the modulated signal; a second envelope detector (442b) that is responsive to the phase locked loop; and a comparator (443) that is responsive to the first and second envelope detectors to produce the amplitude signal.

10. A system according to claim 8, wherein the automatic gain control subsystem further comprises: first envelope detector (442a) that is responsive to the modulated signal; second envelope detector (442b) that is responsive to the amplifier; and a comparator (443) that is responsive to the first and second envelope detectors to produce the amplitude signal.

11. A system according to claim 7, wherein the amplitude tracking subsystem farther comprises: an envelope detector that is responsive to the modulated signal (442a) to produce the amplitude signal.

12. A system according to claim 7, wherein the phase tracking system further comprises a limiter (1120) between the quadrature modulator (420) and the phase locked loop.

**Patentansprüche**

1. Modulationssystem, umfassend: einen Digitalsignalprozessor (920), der Inphase- (922), Quadraturphasen- (924) und Amplitudensignale (926) aus einem Basisbandsignal (912) erzeugt; einen Modulator (930), der die Inphase- und Quadraturphasensignale moduliert, um ein moduliertes Signal zu erzeugen; einen Phasenregelkreis (940), der auf das modulierte Signal anspricht, wobei der Phasenregelkreis einen gesteuerten Oszillator (942) mit einem gesteuerten Oszillatorausgang und einen Verstärker (950) mit einem Signaleingang, einem Amplitudensteuereingang und einem Ausgang umfasst, wobei der Signaleingang auf den gesteuerten Oszillatorausgang (944) anspricht, und der Amplitudensteuereingang auf das Amplitudensignal (926) anspricht,

wobei der Phasenregelkreis einen gesteuerten Oszillatoreingang und den gesteuerten Oszillatorausgang umfasst, wobei die Rückkopplungsschleife einen Mischer umfasst, der auf einen Empfangsoszillator anspricht, **dadurch gekennzeichnet, dass** der Modulator (1650) in der Rückkopplungsschleife zwischen dem gesteuerten Oszillatorausgang (1606) und dem Mischer (1660) ist, wobei der Modulator die Inphase-und Quadraturphasensignale auf ein Signal moduliert, das vom gesteuerten Oszillator (1606) abgeleitet ist.

2. System nach Anspruch 1, wobei die Inphase- und Quadraturphasensignale normalisierte Inphase- und Quadraturphasensignale sind, derart dass das modulierte Signal ein moduliertes Signal mit konstanter Amplitude ist.

3. System nach Anspruch 2, wobei der Digitalsignalprozessor (920') das normalisierte Inphase-Signal als eines von einem Cosinus und einem Sinus eines Winkels Theta erzeugt, und das normalisierte Quadratursignal als den anderen von einem Cosinus und einen Sinus des Winkels Delta erzeugt, wobei Theta ein Winkel ist, dessen Tangente das Quadraturphasensignal geteilt durch das Inphase-Signal ist.

4. Verfahren nach Anspruch 3, wobei der Digitalsignalprozessor (920') das Amplitudensignal als eine Quadratwurzel einer Summe des Inphase-Signals im Quadrat und des Quadraturphasensignals im Quadrat erzeugt.

5. System nach Anspruch 1, ferner umfassend ein Leistungssteuersignal (982), wobei der Amplitudensteuereingang auf das Amplitudensignal und das Leistungssteuersignal (982) anspricht.

6. System nach Anspruch 1, ferner umfassend: einen Leistungsverstärker (960), der auf den Ausgang des Verstärkers mit einem Signaleingang, einem Amplitudensteuereingang und einem Ausgang anspricht, und eine Sendeantenne (970), die auf den Leistungsverstärker anspricht.

7. Modulationssystem, umfassend: einen Quadraturmodulator (420), der Inphase- und Quadraturphasensignale moduliert, um ein moduliertes Signal zu erzeugen; ein Phasenverfolgungssubsystem (430), das auf den Quadraturmodulator (420) anspricht, um ein Phasensignal (432) zu erzeugen, das auf Phasenänderungen im modulierten Signal anspricht und das von Amplitudenänderungen im modulierten Signal unabhängig ist; ein Amplitudenverfolgungssubsystem (440), das auf den Modulator (420) anspricht, um ein Amplitudensignal (422) zu erzeugen, das auf Amplitudenänderungen im modulierten Signal anspricht und das von Phasenänderungen im modulierten Signal unabhängig ist; und einen Verstärker (450) mit einem Signaleingang, einem Amplitudensteuereingang und einem Ausgang, wobei der Signaleingang auf das Phasensignal (432) anspricht, und der Amplitudensteuereingang auf das Amplitudensignal (422) anspricht, wobei das Phasenverfolgungssubsystem (430) einen Phasenregelkreis umfasst, der auf das modulierte Signal anspricht, wobei der Phasenregelkreis einen gesteuerten Oszillator mit einem gesteuerten Oszillatorausgang umfasst, der das Phasensignal erzeugt,

wobei der Phasenregelkreis einen gesteuerten Oszillatoreingang und den gesteuerten Oszillatorausgang umfasst, wobei die Rückkopplungsschleife einen Mischer umfasst, der auf einen Empfangsoszillator anspricht, **dadurch gekennzeichnet, dass** der Modulator (1650) in der Rückkopplungsschleife zwischen dem gesteuerten Oszillatorausgang (1606) und dem Mischer (1660) ist, wobei der Modulator die Inphase-und Quadraturphasensignale auf ein Signal moduliert, das vom gesteuerten Oszillator abgeleitet ist.

8. System nach Anspruch 7, wobei das Amplitudenverfolgungssystem (440) ein automatisches Verstärkungssteuerungssubsystem umfasst, das auf das modulierte Signal anspricht, um das Amplitudensignal zu erzeugen.

9. System nach Anspruch 8, wobei das automatische Verstärkungssteuerungssubsystem ferner umfasst: einen ersten Hüllkurvendetektor (442a), der auf das modulierte Signal anspricht; einen zweiten Hüllkurvendetektor (442b), der auf den Phasenregelkreis anspricht; und einen Komparator (443), der auf die ersten und zweiten Hüllkurvendetektoren anspricht, um das Amplitudensignal zu erzeugen.

10. System nach Anspruch 8, wobei das automatische Verstärkungssteuerungssubsystem ferner umfasst: einen ersten Hüllkurvendetektor (442a), der auf das modulierte Signal anspricht; einen zweiten Hüllkurvendetektor (442b), der auf den Verstärker anspricht; und einen Komparator (443), der auf die ersten und zweiten Hüllkurvendetektoren anspricht, um das Amplitudensignal zu erzeugen.

**11.** System nach Anspruch 7, wobei das Amplitudenverfolgungssubsystem ferner umfasst: einen Hüllkurvendetektor, der auf das modulierte Signal (442a) anspricht, um das Amplitudensignal zu erzeugen.

**12.** System nach Anspruch 7, wobei das Phasenverfolgungssubsystem ferner einen Begrenzer (1120) zwischen dem Quadraturmodulator (420) und dem Phasenregelkreis umfasst.

**Revendications**

**1.** Système de modulation comprenant : un processeur de signal numérique (920) qui génère des signaux en phase (922), en quadrature de phase (924) et d'amplitude (926) à partir d'un signal en bande de base (912) ; un modulateur (930) qui module les signaux en phase et en quadrature de phase pour produire un signal modulé ; une boucle à phase asservie (940) qui est sensible au signal modulé, la boucle à phase asservie comprenant un oscillateur commandé (942) ayant une sortie d'oscillateur commandé ; et un amplificateur (950) ayant une entrée de signal, une entrée de commande d'amplitude et une sortie, dans lequel l'entrée de signal est sensible à la sortie d'oscillateur commandé (944) et l'entrée de commande d'amplitude est sensible au signal d'amplitude (926),
dans lequel la boucle à phase asservie comprend une entrée d'oscillateur commandé et la sortie d'oscillateur commandé, la boucle de rétroaction comprenant un mélangeur qui est sensible à un oscillateur local, **caractérisé en ce que** le modulateur (1650) est dans la boucle de rétroaction entre la sortie d'oscillateur commandé (1606) et le mélangeur (1660), dans lequel le modulateur module les signaux en phase et en quadrature de phase sur un signal dérivé de l'oscillateur commandé (1606).

**2.** Système selon la revendication 1, dans lequel les signaux en phase et en quadrature de phase sont des signaux en phase et en quadrature de phase normalisés, de sorte que le signal modulé soit un signal modulé à amplitude constante.

**3.** Système selon la revendication 2, dans lequel le processeur de signal numérique (920') génère le signal en phase normalisé comme un d'un cosinus et d'un sinus d'un angle thêta et génère le signal en quadrature de phase normalisé comme l'autre d'un cosinus et d'un sinus de l'angle thêta, où thêta est un angle dont la tangente est le signal en quadrature de phase divisé par le signal en phase.

**4.** Système selon la revendication 3, dans lequel le processeur de signal numérique (920') génère le signal d'amplitude comme une racine carrée d'une somme du signal en phase au carré et du signal en quadrature de phase au carré.

**5.** Système selon la revendication 1, comprenant en outre un signal de commande de puissance (982), dans lequel l'entrée de commande d'amplitude est sensible au signal d'amplitude et au signal de commande de puissance (982).

**6.** Système selon la revendication 1, comprenant en outre : un amplificateur de puissance (960) qui est sensible à la sortie de l'amplificateur ayant une entrée de signal, une entrée de commande d'amplitude et une sortie ; et une antenne d'émission (970) qui est sensible à l'amplificateur de puissance.

**7.** Système de modulation comprenant : un modulateur en quadrature (420) qui module des signaux en phase et en quadrature de phase pour produire un signal modulé ; un sous-système de suivi de phase (430) qui est sensible au modulateur en quadrature (420) pour produire un signal de phase (432) qui est sensible à des changements de phase dans le signal modulé et qui est indépendant de changements d'amplitude dans le signal modulé ; un sous-système de suivi d'amplitude (440) qui est sensible au modulateur (420) pour produire un signal d'amplitude (422) qui est sensible à des changements d'amplitude dans le signal modulé et qui est indépendant de changements de phase dans le signal modulé ; et un amplificateur (450) ayant une entrée de signal, une entrée de commande d'amplitude et une sortie, dans lequel l'entrée de signal est sensible au signal de phase (432) et l'entrée de commande d'amplitude est sensible au signal d'amplitude (422), dans lequel le sous-système de suivi de phase (430) comprend une boucle à phase asservie qui est sensible au signal modulé, la boucle à phase asservie comprenant un oscillateur commandé ayant une sortie d'oscillateur commandé qui produit le signal de phase, dans lequel la boucle à phase asservie comprend une entrée d'oscillateur commandé et la sortie d'oscillateur commandé, la boucle de rétroaction comprenant un mélangeur qui est sensible à un oscillateur local, **caractérisé en ce que** le modulateur (1650) est dans la boucle de rétroaction entre la sortie d'oscillateur commandé (1606) et le mélangeur (1660), dans lequel le modulateur module les signaux en phase et en quadrature de phase sur un signal dérivé de l'oscillateur commandé.

**8.** Système selon la revendication 7, dans lequel le sous-système de suivi d'amplitude (440) comprend un sous-système de commande automatique de gain qui est sensible au signal modulé pour produire le signal d'amplitude.

**9.** Système selon la revendication 8, dans lequel le sous-système de commande automatique de gain comprend en outre : un premier détecteur d'enveloppe (442a) qui est sensible au signal modulé ; un second détecteur d'enveloppe (442b) qui est sensible à la boucle à phase asservie ; et un comparateur (443) qui est sensible aux premier et second détecteurs d'enveloppe pour produire le signal d'amplitude.

10. Système selon la revendication 8, dans lequel le sous-système de commande automatique de gain comprend en outre : un premier détecteur d'enveloppe (442a) qui est sensible au signal modulé ; un second détecteur d'enveloppe (442b) qui est sensible à l'amplificateur ; et un comparateur (443) qui est sensible aux premier et second détecteurs d'enveloppe pour produire le signal d'amplitude.

11. Système selon la revendication 7, dans lequel le sous-système de suivi d'amplitude comprend en outre : un détecteur d'enveloppe qui est sensible au signal modulé (442a) pour produire le signal d'amplitude.

12. Système selon la revendication 7, dans lequel le système de suivi de phase comprend en outre un limiteur (1120) entre le modulateur en quadrature (420) et la boucle à phase asservie.

# FIG. 1
## PRIOR ART

EP 1 368 891 B1

## FIG. 2
## PRIOR ART

I-DATA

Q-DATA

Up-conversion
214 Mixer

RF Bandpass
Filter
(BPF3) Power
Amplifier

202

IF VCO

204

206

IF Bandpass
Filter
(BPF1)

216

RF Bandpass
Filter
(BPF2)

212

Local Oscillator
(LO)

222

Variable
Gain
Amplifier

224

226

Duplex
Filter
234

232

Receiver

## FIG. 3
## PRIOR ART

Up-conversion
214 Mixer

216

I-DATA

Q-DATA

RF Bandpass
Filter
(BPF2) Power
Amplifier

202

IF VCO

RF Bandpass
Filter
(BPF1)

204

222

Variable
Gain
Amplifier

224

226

Duplex
Filter
234

232

212

Local Oscillator
(LO)

Receiver

**FIG. 4**

**FIG. 10**

14

FIG. 5

Phase-Frequency Detector

Transmit VCO 430'

500

510 TX IF VCO+ PLL

I-DATA 420

Q-DATA 422

535a ÷M

537 P(F)D

Low-Pass Filter 538a

532

450 VGA1

460

Antenna 470

480 Duplexer

535b

÷N

539

Low-Pass Filter 538b

533

VGA2 446

442a 442b

Matched Pair of Envelope Detectors

445 Adjustable Delay

534 Receiver (Rx) LO + Channel Synth.

490

Receiver

Comparator 443

Low-Pass Filter 444

440'

EP 1 368 891 B1

FIG. 6

EP 1 368 891 B1

FIG. 7

FIG. 8

FIG. 9

TX VCO INTEGRATED

VGA/PA Driver

INTEGRATED TX VCO

AUX LO 510

190.40 MHz
155.52 MHz

LIMITER 1120

P(F)D 1140

155.52 MHz
190.40 MHz

836 MHz

1142a

1144a

432a

1150a

836 MHz
+10dBm

533a

533b

1144b

1142b

432b

1880 MHz

VGA/PA Driver

1150b

1880 MHz
+10dBm

MAIN LO 534

991.52 MHz
2035.52 MHz

AMPLITUDE TRACKING

440''''

442

1110

POWER CONTROL

900

420

I Q

EP 1 368 891 B1

FIG. 11

FIG. 13

FIG. 12

EP 1 368 891 B1

FIG. 14

FIG. 15

EP 1 368 891 B1

# FIG. 16

FIG. 17

EP 1 368 891 B1

FIG. 18

Antenna 470

T/R Switch 580

488

490

Receiver

460 PA

430'

Phase-Frequency Low-Pass Transmit
Detector Filter VCO
537 538a 532

535a 535b
÷M P(F)D ÷N

539

Low-Pass Filter 538b

533

Receiver (Rx)
LO +
Channel Synth.

534

I/Q 1670

Adjustable Delay
445

446 VGA2

Low-Pass Filter 444

Comparator 443

442b
442a
Matched Pair
of Envelope
Detectors

440'

510

TX IF VCO+
PLL

FIG. 19

EP 1 368 891 B1

FIG. 20

EP 1 368 891 B1

FIG. 21

EP 1 368 891 B1

# FIG. 22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5412351 A
- EP 0998088 A
- WO 0059172 A
- EP 1170915 A
- US 5313173 A
- WO 9516304 A
- US 4481672 A